# EUROPEAN PATENT APPLICATION

(11) **EP 2 240 006 A1**
(43) Date of publication of application: **13.10.2010**
(21) Application number: 09008641.4
(22) Date of filing: 01.07.2009
(51) Int. Cl.: H05K 3/32, C09J 9/02, H01L 21/60, H01R 4/04

(54) **Ambient-curable anisotropic conductive adhesive**

(30) Priority: 07.04.2009 US 419303
(71) Applicant: Teamchem Company, Bar-der City T'ao yuan (TW)
(72) Inventor: Yeh, Syh-Tau, Jhongli City Taoyuan County (TW)
(74) Representative: Weber, Joachim

(57) **Abstract**

Compositions of ambient-curable anisotropic conductive adhesive comprising an ambient-curable epoxy resin system and a conductive powder are proposed. It can be cured under ambient conditions using common magnet for clamping mechanism. This greatly simplifies many electronic repairs or Do-It-Yourself types of application. This anisotropic conductive adhesive can also be applied using traditional hot-bar laminator, but at lowered temperatures, and this is bound to open up new application possibilities.

## Description

The present invention relates to a composition of ambient-curable anisotropic conductive adhesive according to the pre-characterizing clause of claim 1.

As propelled by consumer preferences, electronic products have become smaller in size, lighter and more compact. It is also required that the electronic products are able to process more information at higher speeds. Consequently, electronic product manufacturers are facing the issue of having to connect electric components at ever increasing precisions.

Although the traditional method of soldering has been proven to be fairly reliable and easy to operate, it has troubles with connecting circuit parts at very fine pitches. Different anisotropic conductive materials, such as anisotropic conductive film (ACF) or anisotropic conductive paste (ACP) have all found some success in resolving this issue, but they also have some drawbacks.

This in mind, the present invention aims at providing a composition of anisotropic conductive material that avoids conduction failure and provides a much wider operation window for the anisotropic conductivity.

This is achieved by a composition of anisotropic conductive material according to claim 1. The dependent claims pertain to corresponding further developments and improvements.

As will be seen more clearly from the detailed description below, the claimed composition of anisotropic conductive material includes a conductive powder dispersed in an ambient-curable epoxy resin system.

In the following, the invention is further illustrated by way of example, taking reference to the accompanying drawings. Thereof:
- FIG. 1: demonstrates reference x-, y- and z-coordinate system and the conductive planes.
- FIG. 2: shows the wiring pattern on RPCB & FPCB which are connected with ACA, and anisotropic conductivities are measured on the square pads at top.
- FIG. 3: is the schematic drawing showing the lamination configuration of FPCB to RPCB.
- FIG. 4: shows electric resistances versus trace length for conductive traces extending from FPCB to RPCB.

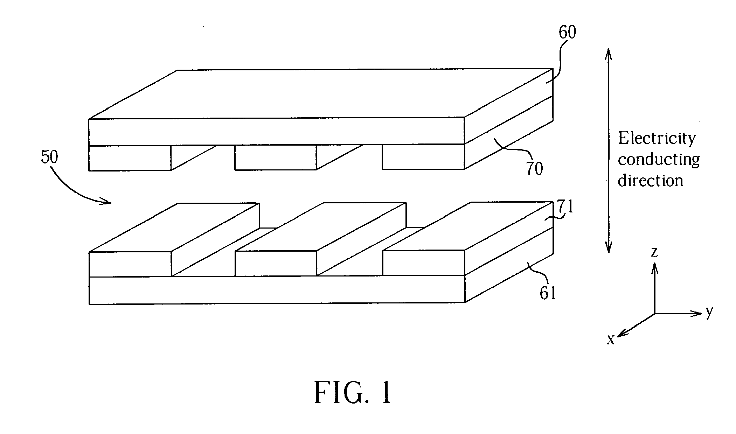

The present invention relates to an anisotropic conductive adhesive that can be cured under ambient conditions. As shown in FIG. 1, the anisotropic conductive material (not explicitly shown) is filled in the gaps 50 between the conductive plane 60 and conductive plane 61 with bumps 70, 71 in between. This anisotropic conductive material allows electricity to be conducted only in z-direction (the direction perpendicular to the adhesive film), but not along x- and y- directions (x- and y-directions lie on the adhesive film).

This ambient-curable anisotropic conductive adhesive consists of a conductive particle uniformly dispersed in a liquid ambient-curable epoxy resin system which comprises of an epoxy resin and an ambient-curable hardener. Filamentary nickel powders have been found to be well suited for this purpose. Their high specific surface areas and porous deformable structures are postulated to be helping factors for enhancing electrical conductivity. Examples of commercially available filamentary nickel powder are Inco® Type 210, 210H, 240 and 255. Fine flake nickel powders, although not as effective, can also serve this purpose. Examples of fine flake nickel powders are Inco® HCA-1, Fine Leafing and Fine Leafing Pigment Grade. The amount of conductive powders added is in the range of 1-10% based on the total weight of the mixture.

The ambient-curable epoxy resin consists of a liquid epoxy resin or a blend of liquid epoxy resins with a liquid ambient-curable harder. Common commercially available liquid epoxy resins, such as Bisphenol-A, Bisphenol-F, Phenolic, Novolac, and flexibilized epoxy resins can be used. Examples of epoxy resins are Dow Chemicals DER 383, DER 351 and DER 324. Many commercially available liquid ambient-curable hardeners, usually of the amine type, such as modified amines or polyamides, can be used. Examples of ambient-curable hardener are Sanho Chemical Kingcure N-768, K-863A and X-963. Other additives, such as de-foamer, thixotropic reagent may be added when needed.

Composition examples of ambient-curable anisotropic conductive adhesives are shown in Table 1. These examples illustrate the basic concept of this invention, and are by no means meant to be restrictive. In these examples Ingredients 1-7 are weighed, and then dispersed by a high-speed agitator to form the main component. It is mixed with the hardener right before the coating operation.

| Table 1 | | | | | |
|---|---|---|---|---|---|
| No. | Ingredients | Example 1 | Example 2 | Example 3 | Example 4 |
| 1 | Dow DER 383 | 100.0 | 100.0 | 85.0 | 85.0 |
| 2 | Dow DER 92466.00 | - | - | 10.0 | 10.0 |
| 3 | CVC Hypox DA-323 | - | - | 5.0 | 5.0 |
| 4 | Momentive TSA-750S | 0.5 | 0.5 | 0.5 | 0.5 |
| 5 | Degussa Aerosil R970 | 2.5 | 2.5 | 2.5 | 2.5 |
| 6 | Degussa Aerosil A300 | 2.5 | 2.5 | 2.5 | 2.5 |
| 7 | Inco Type 210 | 5.0 | 10.0 | 5.0 | 10.0 |
| | Sum | 110.5 | 115.5 | 110.5 | 115.5 |
| Main component: Ingredients 1-7 are weighed, and then dispersed by a high-speed agitator. | | | | | |
| 8 | Truetime 5010 | 100.0 | 100.0 | 100.0 | 100.0 |
| | Sum | 210.5 | 215.5 | 210.5 | 215.5 |
| Ingredient 8 is the ambient-curable hardeners. It was mixed with the main component right before application. All are in parts per hundred parts of resin (phr) by weight. | | | | | |
| I | Contact resistance (Ω); 23°C x 3 hours using magnet | < 0.1 | < 0.1 | < 0.1 | < 0.1 |
| II | Contact resistance (Ω); 85°C x 3 minutes using hot-bat | < 0.1 | < 0.1 | < 0.1 | < 0.1 |
| III | 90°-peel strength (kgf/cm) | > 0.5 | > 0.5 | > 0.5 | > 0.5 |

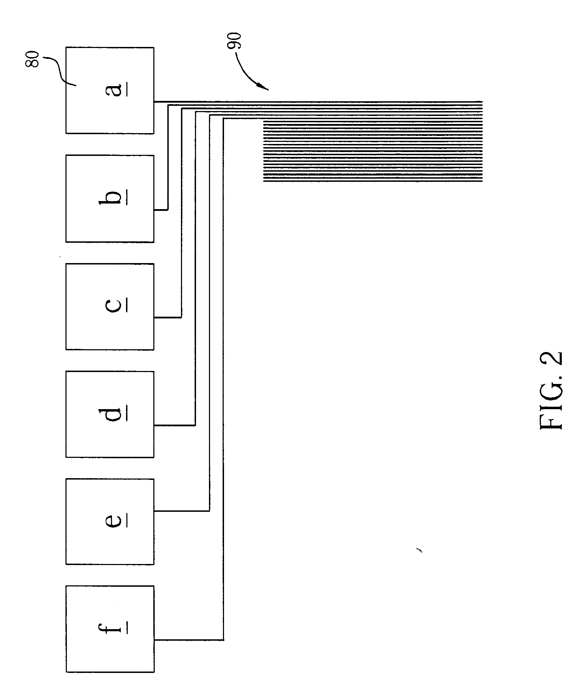

To examine the anisotropic conductivity of the ACA, printed circuit boards of the wiring pattern 90 shown in Figure 2 were made. The idea of this wiring pattern 90 is to construct parallel conductive trace of 4-mil (100 µm) width and separated by a distance of 8 mils (200 µm), hence the marking of 4/8 on the Figure. This same wiring pattern 90 was applied to make both RPCB (Rigid Printed Circuit Boards using FR-4 as the substrate) and FPCB (Flexible Printed Circuit Boards using polyimide film as the substrate). Six larger conductive square pads 80 of 5-mm x 5-mm dimension were connected to the first six conductive traces at the ends so that electric resistance of the conductive trace can be conveniently measured with a common 2-probe electrical multi-meter or the more accurate 4-probe low-resistance meter.

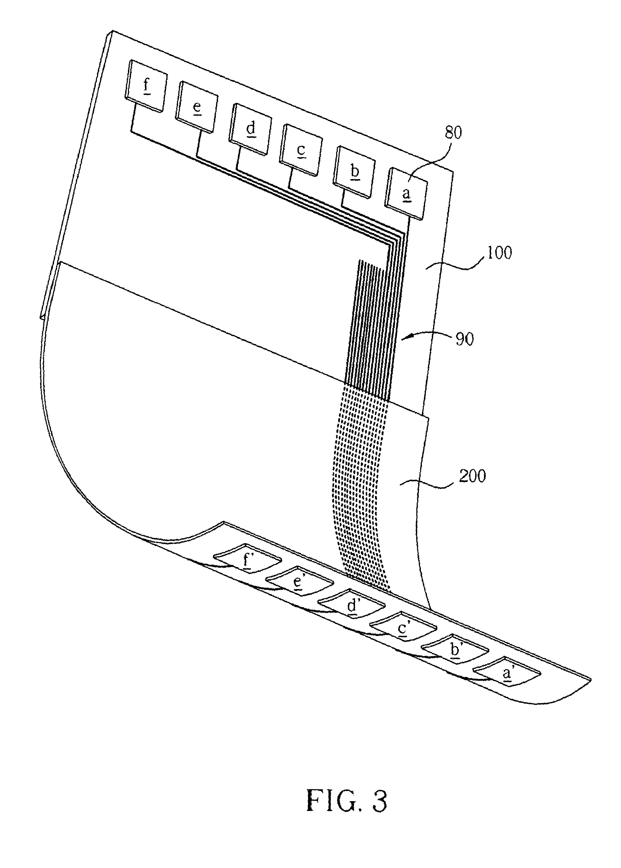

Different ACA compositions were coated onto to the RPCB 100 (Rigid Printed Circuit Boards using FR-4 as the substrate) with wiring pattern 90 of Figure 2, a FPCB 200 of the same wiring pattern 90 is then placed on top of the RPCB 100, a hot-bar laminator is then used to align the conductive traces on both RPCB 100 and FPCB 200 so that the traces are connected through ACA layer. A schematic of this operation is shown in Figure 3.

In this experiment, the lamination processes were carried out via two different methods. The first method uses CCD (mounted on the hot-bar) for alignment of the conductive traces, the aligned assembly is then temporarily fixed in position by placing a pressure-sensitive adhesive tape over the joint, the assembly is moved to a flat steel surface, a magnet is then place on the top of the assembly joint to ensure close contact of the two printed circuit boards during the entire ambient curing process, as this generally requires 2-3 hours to complete under ambient condition.

Another method uses hot-bar for alignment and lamination in one step, as is commonly performed with regular ACF or ACP operations. This is carried out at 85°C for 3 minutes under a pressure of 2,000 Newton over a square area of 2 mm x 7 mm. The hot-bar lamination generally gives better and more consistent results.

After lamination, the electrical resistance of separate conductive traces can be measured over the corresponding pads 80 on RPCB 100 and FPCB 200 by folding FPCB 200 over so that the conductive pads 80 on FPCB 200 can be next their corresponding conductive pads 80 on the RPCB 100. In this configuration, measurement of the electrical resistance of the conductive traces between two corresponding pads 80 (one on RPCB 100 and the other on FPCB 200) can be easily carried out.

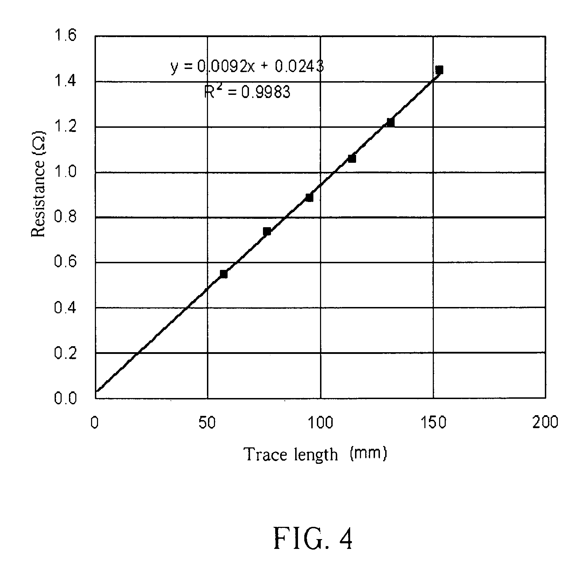

Using the 4-probe low-resistance meter (Mitsuibishi Chemical Loresta -EP MCP T360) for more accurate resistance readings, a typical result is shown in Table 2. In this Table, the first column denoted as: a-a', b-b', c-c', d-d', e-e' and f-f' represents those 6 pairs of square pads 80 from right to left, where a, b, c, d, e and f represents pads on RPCB 100 and a', b', c', d', e' and f' represents pads 80 on FPCB 200. The trace lengths between a-a', b-b' ...are measured with a ruler and are recorded in the second column. The electrical resistances between a-a', b-b' ...are recorded in the third column. Plotting the resistance versus conductive trace length yields a result shown in Figure 4. Applying linear regression over these data generates nearly perfect fit with correlation coefficient reaching 0.998, indicating very high reliability. Extrapolating this line to zero-trace length, i.e. intercept at y-axis, gives the actual contact resistance of ACA-film which is only 0.024 Ω in Figure 4, a very low resistance indeed.

Also shown in Table 2 is a parameter denoted as contact impedance which is obtained by multiplying the value of contact resistance (0.024Ω) by the contact area (0.002 cm²) of the conductive trace, and it is shown to be 4.8 x 10⁻⁵ Ω·cm². The contact area is obtained by multiplying the width of the conductive trace (0.01 cm) by the width of the hot-bar (0.2 cm), hence 0.002 cm². This contact impedance is speculated to be an intrinsic value for any given ACA composition. It should remain the same regardless of the contact area. The contact resistance, on the other hand, should be inversely proportional to contact area, i.e. the larger the contact area and the smaller the contact resistance. This relationship can be expressed mathematically as:
R = σ / A; Where R: contact resistance (Ω); σ: contact impedance (Ω·cm².); A: area (cm²)

**Table 2. ACA - hot-bar @ 85°C x 3 minutes**

| | | |
|---|---|---|
| coating width: | 0.2 | cm |
| A (contact area): | 0.002 | cm² |
| R(contact resistance): | 0.024 | Ω |
| σ(contact Impedance): | 4.8E-05 | Ω.cm² |

| pad | trace length (mm) | R (Ω) |
|---|---|---|
| a-a' | 57 | 0.55 |
| b-b' | 76 | 0.74 |
| c-c' | 95 | 0.89 |
| d-d' | 114 | 1.06 |
| e-e' | 131 | 1.22 |
| f-f' | 153 | 1.45 |

Contact resistances derived from extrapolation are also listed in Table 1. Their values are all below 0.1Ω, which is very good for all practical purposes. The peel strength for these compositions are all greater than 0.5 kgf/cm, which is satisfactory for most applications.

## Claims

1. A composition of ambient-curable anisotropic conductive adhesive, **characterized by**:
a conductive powder; and an ambient-curable epoxy resin system, wherein the conductive powder is dispersed in the ambient-curable epoxy resin system.

2. The composition of the ambient-curable anisotropic conductive adhesive according to claim 1, **characterized in that** the conductive powder is a filamentary or flake nickel powder.

3. The composition of the ambient-curable anisotropic conductive adhesive according to claim 1, **characterized in that** the weight percentage of the conductive powder, relative to the total weight of the mixture, is in the range of 1-10%.

4. The composition of the ambient-curable anisotropic conductive adhesive according to claim 1, **characterized in that** the ambient-curable epoxy resin system comprising an epoxy resin or a blend of epoxy resins selected from a group of liquid epoxy resin consisting of Bisphenol-A, Bisphenol-F, Phenolic, Novolac, and flexibilized epoxy resins.

5. The composition of the ambient-curable anisotropic conductive adhesive according to claim 1, **characterized by** common ambient-curable hardener.

6. The composition of the ambient-curable anisotropic conductive adhesive according to claim 5, **characterized in that** the common ambient-curable hardener comprises modified amines or polyamides.

7. The composition of the ambient-curable anisotropic conductive adhesive according to claim 1, **characterized by** de-foamer.

8. The composition of the ambient-curable anisotropic conductive adhesive according to claim 1, **characterized by** thixotropic reagent.
